(19) Europäisches Patentamt
European Patent Office
Office européen des brevets

(11) **EP 3 029 745 B1**

(12) **EUROPEAN PATENT SPECIFICATION**

(45) Date of publication and mention
of the grant of the patent:
**08.11.2017   Bulletin 2017/45**

(51) Int Cl.:
**H01L 31/107** *(2006.01)*       **H01L 31/0312** *(2006.01)*
**H01L 31/0352** *(2006.01)*

(21) Application number: **13892516.9**

(22) Date of filing: **28.08.2013**

(86) International application number:
**PCT/CN2013/082504**

(87) International publication number:
**WO 2015/027416 (05.03.2015 Gazette 2015/09)**

(54) **AVALANCHE PHOTODIODE**

LAWINENPHOTODIODE

PHOTODIODE À AVALANCHE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**08.06.2016   Bulletin 2016/23**

(73) Proprietor: **Huawei Technologies Co., Ltd.
Longgang District
Shenzhen, Guangdong 518129 (CN)**

(72) Inventor: **PAN, Xu
Shenzhen
Guangdong 518129 (CN)**

(74) Representative: **Goddar, Heinz J.
Boehmert & Boehmert
Anwaltspartnerschaft mbB
Pettenkoferstrasse 22
80336 München (DE)**

(56) References cited:
**EP-A1- 0 571 944        EP-A2- 0 629 005
CN-A- 101 814 537        CN-A- 103 022 218
US-A- 5 600 152          US-A- 5 723 877**

## Description

## TECHNICAL FIELD

The present invention relates to the field of electronic devices, and in particular, to an avalanche photodiode.

## BACKGROUND

With the development of communications technologies, a fiber optic communications technology becomes a main manner for information transmission because of its advantages of wide transmission frequency band, high immunity to interference, and small signal attenuation. The avalanche photodiode is an important optical-to-electrical signal conversion component in the fiber optic communications technology, and noise performance of the avalanche photodiode is critical to sensitivity of signals. Therefore, how to reduce noise of the avalanche photodiode becomes an important issue.

In the prior art, an excess noise factor is reduced by changing a material of a multiplication region of the avalanche photodiode, and a ratio K of a hole ionization rate to an electron ionization rate of the changed material of the multiplication region is lower. For example, for a SiGe (silicon germanium) avalanche photodiode, when a Si material is used in place of a Ge material as the material of the multiplication layer, the ratio K of the hole ionization rate to the electron ionization rate can be reduced, thereby reducing the excess noise factor, and achieving an objective of reducing noise.

During the implementation of the present invention, it is found that the prior art has at least the following problems:

In the prior art, noise of the avalanche photodiode is reduced by using a method of changing the material of the multiplication region. Because the K value is an inherent property of the material, the K value of the multiplication region whose material has been changed is restricted by the material, and the excess noise factor and the noise cannot be further reduced.

EP 0 629 005 A2 discloses an avalanche photodiode multilayer structure comprising an absorption layer for absorbing photons and subsequent generation of electron hole pairs, a field relaxation layer in contact with the absorption layer and a multiplication layer in contact with the field relaxation layer. The multiplication layer comprises a plurality of periods of first and second layers. The first layer has a thickness of 150 angstroms and the second layer has a thickness of 50 angstroms.

## SUMMARY

## Technical Problem

To resolve an issue of further reducing an excess noise factor and noise, embodiments of the present invention provide an avalanche photodiode, aiming to resolve a technical issue of reducing a noise factor and noise of an inherent material.

## Technical Solution

According to a first aspect, the avalanche photodiode includes a P-type contact layer, a light absorption layer, a compositionally-graded symmetrical multiplication layer, and an N-type contact layer, where
the P-type contact layer is connected to the light absorption layer, the light absorption layer is connected to the compositionally-graded symmetrical multiplication layer, and the compositionally-graded symmetrical multiplication layer is connected to the N-type contact layer; and the compositionally-graded symmetrical multiplication layer is configured to amplify the electrical signal, and the compositionally-graded symmetrical multiplication layer has a centrosymmetric structure and includes multiple graded layers.

In a first possible implementation manner of the first aspect, a material of the avalanche photodiode is a SiGe material.

With reference to the first possible implementation manner of the first aspect, in a first possible implementation manner, the avalanche photodiode further includes a charge layer, where
the charge layer is configured to adjust an electric field distribution of each layer, the charge layer has a doping concentration of greater than or equal to $10^{17}/cm^3$, the charge layer has a thickness range of 50 nm to 200 nm, and the charge layer is located between the light absorption layer and the symmetrical graded multiplication layer.

With reference to the first possible implementation manner of the first aspect, in a second possible implementation manner, the P-type contact layer has a doping concentration of greater than or equal to $10^{19}/cm^3$, and the P-type contact layer has a thickness range of 100 nm to 200 nm.

With reference to the first possible implementation manner of the first aspect, in a third possible implementation manner, the light absorption layer has a thickness range of 200 nm to 2000 nm.

With reference to the first possible implementation manner of the first aspect, in a fourth possible implementation manner, the light absorption layer is a P-doped light absorption layer, and the P-doped light absorption layer has a doping concentration of greater than or equal to $10^{17}/cm^3$;
or
the light absorption layer is an undoped light absorption layer, and the undoped light absorption layer has a doping concentration of less than or equal to $10^{16}/cm^3$.

In a second possible implementation manner of the first aspect, the N-type contact layer has a doping concentration of greater than or equal to $10^{19}/cm^3$, and the N-type contact layer is connected to the compositionally-graded symmetrical multiplication layer.

In a third possible implementation manner of the first aspect, a composition of the compositionally-graded symmetrical multiplication layer is a lattice mismatched material that is symmetrically distributed, and the symmetrical distribution refers to that as positions of the graded layers in the compositionally-graded symmetrical multiplication layer change, content of a first crystal material in the graded layers increases from 0 to 100%, and then decreases from 100% to 0.

In a fourth possible implementation manner of the first aspect, a band gap width of a material of two ends in the compositionally-graded symmetrical multiplication layer is less than a band gap width of the graded layer.

In a fifth possible implementation manner of the first aspect, a thickness of each graded layer in the compositionally-graded symmetrical multiplication layer is less than or equal to a reciprocal of an ionization rate of a multiplied carrier of the graded layer.

**Beneficial Effects**

Beneficial effects brought by the technical solutions in the embodiments of the present invention are as follows:

The avalanche photodiode provided by the embodiments of the present invention includes: a P-type contact layer, a light absorption layer, a compositionally-graded symmetrical multiplication layer, and an N-type contact layer, where the compositionally-graded symmetrical multiplication layer is configured to amplify the electrical signal, and the compositionally-graded symmetrical multiplication layer has a centrosymmetric structure and includes multiple graded layers. According to the technical solutions in the embodiments of the present invention, the compositionally-graded symmetrical multiplication layer is used to suppress ionization of a carrier, thereby further reducing an excess noise factor and noise by reducing the K value.

**BRIEF DESCRIPTION OF DRAWINGS**

To describe the technical solutions in the embodiments of the present invention more clearly, the following briefly introduces the accompanying drawings required for describing the embodiments. Apparently, the accompanying drawings in the following description show merely some embodiments of the present invention, and a person of ordinary skill in the art may still derive other drawings from these accompanying drawings without creative efforts.

    FIG. 1 is a schematic structural diagram of an avalanche photodiode according to a first embodiment of the present invention;
    FIG. 2 is a schematic structural diagram of an avalanche photodiode according to a second embodiment of the present invention; and
    FIG. 3 is a schematic structural diagram of a compositionally-graded symmetrical multiplication layer according to a third embodiment of the present invention.

**DESCRIPTION OF EMBODIMENTS**

To make the objectives, technical solutions, and advantages of the present invention clearer, the following further describes the embodiments of the present invention in detail with reference to the accompanying drawings.

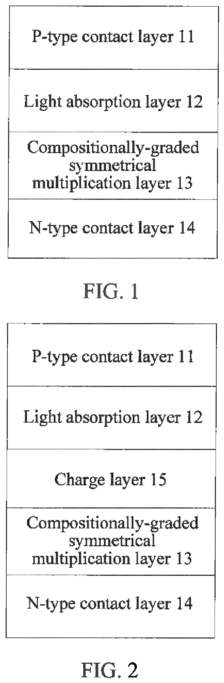

FIG. 1 is a schematic structural diagram of an avalanche photodiode according to a first embodiment of the present invention. Referring to FIG. 1, the avalanche photodiode includes a P-type contact layer 11, a light absorption layer 12, a compositionally-graded symmetrical multiplication layer 13, and an N-type contact layer 14.

The P-type contact layer 11 is connected to the light absorption layer 12, the light absorption layer 12 is connected to the compositionally-graded symmetrical multiplication layer 13, and the compositionally-graded symmetrical multiplication layer 13 is connected to the N-type contact layer 14.

The compositionally-graded symmetrical multiplication layer 13 is configured to amplify the electrical signal, and the compositionally-graded symmetrical multiplication layer 13 has a centrosymmetric structure and includes multiple graded layers.

The P-type contact layer 11 is configured to form a P-side ohm contact in a P-N junction.

The P-type contact layer 11 has a doping concentration of greater than or equal to $10^{19}/cm^3$, and the P-type contact layer 11 has a thickness range of 100 nm to 200 nm.

Specifically, the P-type contact layer 11 is formed by doping monocrystalline silicon with a group III element such as boron, aluminum, gallium, or indium to replace positions of silicon atoms in the lattice, where silicon and the group III element are bonded by a covalent bond to generate an excess of holes. Doping with more group III elements indicates that more holes are generated in the P-type contact layer 11.

When an external voltage is applied to two ends of the avalanche photodiode, one of the ends is connected to the P-type contact layer 11, and conducts electricity through the P-type contact layer 11.

The light absorption layer 12 is configured to absorb an optical signal and convert the optical signal into an electrical signal. The light absorption layer 12 is connected to the P-type contact layer 11.

The light absorption layer 12 has a thickness range of 200 nm to 2000 nm.

After receiving an optical signal, the light absorption layer 12 absorbs the optical signal, and generates an electron-hole pair. The electron-hole pair moves under action of an electric field to form an electrical signal, thereby completing conversion of an optical signal to an electrical signal.

Content of a crystalline material in the compositionally-graded symmetrical multiplication layer 13 is symmetrically distributed. The symmetrical distribution refers to that as positions of the graded layers in the compositionally-graded symmetrical multiplication layer 13 differ, the content of the crystal material in the graded layers increases from 0 to 100%, and then decreases from 100% to 0.

The compositionally-graded symmetrical multiplication layer 13 generates a large quantity of electron-hole pairs by using an avalanche multiplication effect, and amplify the electrical signal that is generated by the light absorption layer 12.

The avalanche multiplication effect refers to that after a reverse bias is applied to the two ends of the avalanche photodiode, an electron or a hole gains energy under action of an electric field and is accelerated. Higher energy indicates a higher speed. During movement, the carrier collides with an electron on a covalent bond, intrinsic excitation occurs, and an electron-hole pair is generated. The process is repeated. A large quantity of electron-hole pairs can be generated instantaneously.

The compositionally-graded symmetrical multiplication layer 13 includes multiple graded layers. Silicon content of the graded layers is different, and therefore band gap widths of the graded layers are different, and a heterostructure that is generated reduces an excess noise factor.

The band gap width refers to a conducting capability of a material. A smaller band gap width indicates a stronger conducting capability; a larger band gap width indicates a weaker conducting capability. For example, for a semiconductor material having a relatively small band gap width, when temperature rises, an electron may be excited, so that the semiconductor material is electrically conductive. For an insulator material having a very large band gap width, the insulator material is a poor conductor even at a relatively high temperature. A band gap is an energy region whose density of states is zero in an energy band structure, and is usually used to represent an energy range that is between valence and conduction bands and whose density of states is zero.

Noise performance of the avalanche photodiode is determined by the excess noise factor. A calculation formula of the excess noise factor is shown as follows:

$$F_A = KM + (1-K)(2-M^{-1})$$

where M is a multiplication factor, and K is a ratio of a hole ionization rate $\beta$ to an electron ionization rate $\alpha$, that is, $\beta/\alpha$. When the K value approaches zero, $F_A$ approaches $2-M^{-1}$, and reaches a minimum. When a carrier moves from a wide band gap material to a narrow band gap material, a decrease $\Delta E_c$ in an electron ionization threshold $\Delta E_{th}$ is greater than a decrease $\Delta E_v$ in a hole ionization threshold $\Delta E_{th}$, and an ionization rate has an exponential relationship with an ionization threshold. Therefore, the K value decreases accordingly, and the excess noise factor of the avalanche photodiode that has multiple graded layers is relatively small.

The N-type contact layer 14 is configured to form an N-side ohm contact in the P-N junction. The N-type contact layer 14 has a doping concentration of greater than or equal to $10^{19}/cm^3$. The N-type contact layer 14 is connected to the compositionally-graded symmetrical multiplication layer 13.

The N-type contact layer 14 is formed by doping monocrystalline silicon with a group V element such as phosphorus, arsenic, or antimony to replace positions of silicon atoms in the lattice, where silicon and the group V element are bonded by a covalent bond to generate an excess of electrons. Doping with more group V elements indicates that more electrons are generated in the N-type contact layer 14.

When an external voltage is applied to two ends of the avalanche photodiode, one of the ends is connected to the N-type contact layer 14, and conducts electricity through the N-type contact layer 14.

The avalanche photodiode provided by this embodiment of the present invention includes: a P-type contact layer, a light absorption layer, a compositionally-graded symmetrical multiplication layer, and an N-type contact layer, where the compositionally-graded symmetrical multiplication layer is configured to amplify the electrical signal, and the compositionally-graded symmetrical multiplication layer has a centrosymmetric structure and includes multiple graded layers. In the technical solutions provided by this embodiment of the present invention, the compositionally-graded symmetrical multiplication layer is used to suppress ionization of a carrier, thereby further reducing an excess noise factor and noise by reducing the K value.

Optionally, a material of the avalanche photodiode is a SiGe material.

Silicon has a lattice constant of 0.543 nm, and germanium has a lattice constant of 0.565 nm. Therefore, there is a lattice mismatch of up to 4% between silicon and germanium. When silicon is grown on a germanium material, a silicon thin film experiences a tensile stress. The silicon thin film has a critical thickness, and if the critical thickness is exceeded, defects of the silicon thin film such as cracking are caused, which affects quality of the thin film. To alleviate the problem of low thin film quality that is caused by the lattice mismatch, a symmetrical compositional multiplication layer is used, the abrupt change of 4% in the lattice constant that is from 0.543 of germanium to 0.565 of silicon as content of silicon in the graded layers changes becomes a slow change because of introduction of the graded layers, and the graded layers effectively relax the tensile stress. There is still a critical thickness for the slow change of the lattice mismatch, and to counteract the tensile stress, graded layers that are mirrored are used, so that the whole graded structure is centrosymmetric, and the tensile stresses of the slow change "counteract" each other. At the top and bottom of the compositionally-graded symmetrical multiplication layer, content of silicon is 0, and content of germanium is 100%. The symmetrical graded structure effectively relaxes the stress that is caused by the lattice mismatch, thereby obtaining a high-quality epitaxial thin film, and achieving relatively good noise performance.

Optionally, the avalanche photodiode further includes a charge layer 15.

The charge layer 15 is configured to adjust an electric field distribution of each layer, the charge layer 15 has a doping concentration of greater than or equal to $10^{17}$/cm$^3$, the charge layer has a thickness range of 50 nm to 200 nm, and the charge layer is located between the light absorption layer 12 and the symmetrical graded multiplication layer 13.

FIG. 2 is a schematic structural diagram of an avalanche photodiode according to a second embodiment of the present invention. Referring to FIG. 2, during a reverse bias, the charge layer 15 properly adjusts an electrical field distribution of each layer, so that the avalanche photodiode works in an optimal state.

It should be noted that the charge layer 15 may serve as a part of the absorption layer 12, may serve as a part of the symmetrical graded multiplication layer 13, or may exist as an independent layer.

The avalanche photodiode provided by this embodiment of the present invention includes a P-type contact layer, a light absorption layer, a compositionally-graded symmetrical multiplication layer, and an N-type contact layer, where the compositionally-graded symmetrical multiplication layer is configured to amplify the electrical signal, and the compositionally-graded symmetrical multiplication layer has a centrosymmetric structure and includes multiple graded layers. In the technical solutions provided by this embodiment of the present invention, the compositionally-graded symmetrical multiplication layer is used to suppress ionization of a carrier, thereby further reducing an excess noise factor and noise by reducing the K value. Further, the charge layer is used to optimize the electrical field distribution of the avalanche photodiode, thereby reducing noise.

Optionally, the light absorption layer 12 is a P-doped light absorption layer, and the P-doped light absorption layer has a doping concentration of greater than or equal to $10^{17}$/cm$^3$;
or
the light absorption layer 12 is an undoped light absorption layer, and the undoped light absorption layer has a doping concentration of less than or equal to $10^{16}$/cm$^3$.

When the light absorption layer 12 is the P-doped light absorption layer, the group III element doped in silicon has a doping concentration of $10^{16}$/cm$^3$. At this concentration, when there is an optical signal, excitation of an electron-hole pair is achieved, and an electrical signal is formed.

When the light absorption layer 12 is the undoped light absorption layer, that is, the light absorption layer is not doped with any other material, the light absorption layer has a doping concentration of less than or equal to $10^{16}$/cm$^3$, where the doping concentration is formed by carriers of the light absorption layer, and conversion from an optical signal to an electrical signal can be achieved.

A composition of the compositionally-graded symmetrical multiplication layer is a lattice mismatched material that is symmetrically distributed, and the symmetrical distribution refers to that as positions of the graded layers in the compositionally-graded symmetrical multiplication layer change, content of a first crystal material in the graded layers increases from 0 to 100%, and then decreases from 100% to 0.

The first crystalline material refers to a material with a relatively large band gap width in the compositionally-graded symmetrical multiplication layer. For example, in a SiGe material, a band gap width of Ge is greater than a band gap width of Si, and therefore, the first crystalline material is Si.

As the positions of the graded layers in the compositionally-graded symmetrical multiplication layer change, the content of the first crystalline material in the compositionally-graded symmetrical multiplication layer increases from 0 to 100%, and then decreases from 100% to 0. The whole graded structure is centrosymmetric. The tensile stresses of the slow change "counteract" each other. The symmetrical graded structure effectively relaxes the stress caused by the lattice mismatch, thereby obtaining a high-quality epitaxial thin film, and reducing noise of the avalanche photodiode.

Optionally, a band gap width of a material of two ends in the compositionally-graded symmetrical multiplication layer is less than a band gap width of the graded layer.

It can be known from the above that a larger band gap width of a material indicates a lower conductivity, and a smaller band gap width of a material indicates a higher conductivity. Transition of the band gap widths of the graded layers from small to large and then from large to small is achieved by selecting a material whose band gap width is less than the band gap widths of the graded layers as the material of the two ends of the compositionally-graded symmetrical multiplication layer. In a silicon germanium material, the material of the two ends in the compositionally-graded symmetrical multiplication layer is germanium; in a III-V material, the material of the two ends in the compositionally-graded symmetrical multiplication layer is the material whose band gap width is smaller.

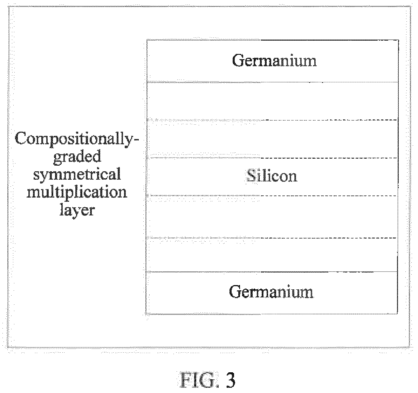

FIG. 3 is a schematic structural diagram of a compositionally-graded symmetrical multiplication layer according to a third embodiment of the present invention. Referring to FIG. 3, a material of the compositionally-graded symmetrical multiplication layer includes silicon and germanium, and content of silicon and germanium is symmetrically distributed in the compositionally-graded symmetrical multiplication layer. A material of two ends of the compositionally-graded symmetrical multiplication layer is germanium, and a material of a middle layer is silicon. Content of silicon in the graded layers from the top down is: from 0 to 100%, and then from 100% to 0. Content of germanium in the graded layers from the top down is: from 0 to 100%, and then from 100% to 0. Content of silicon and germanium in the compositionally-graded symmetrical multiplication layer may be represented by a chemical formula $Si_xGe_{1-x}$, where x has a value range of 0 to 1.

Optionally, a thickness of each graded layer in the compositionally-graded symmetrical multiplication layer is less than or equal to a reciprocal of an ionization rate of a multiplied carrier of the graded layer.

The ionization rate is a quantity of electron-hole pairs that are generated when a carrier passes by a unit distance under action of a strong electrical field. The ionization rate is correlated to the electrical field and a band gap width. The ionization rate exponentially increases as the strength of the electrical field increases, and exponentially decreases as the band gap width increases. For example, when the ionization rate of the multiplied carrier of the graded layer is $\alpha$, the thickness of the graded layer is less than or equal to $1/\alpha$.

The thickness of each graded layer in the compositionally-graded symmetrical multiplication layer is limited within a range, which helps suppress ionization of a carrier, thereby reducing impact of a noise factor.

The avalanche photodiode provided by this embodiment of the present invention includes a P-type contact layer, a light absorption layer, a compositionally-graded symmetrical multiplication layer, and an N-type contact layer, where the compositionally-graded symmetrical multiplication layer is configured to amplify the electrical signal, and the compositionally-graded symmetrical multiplication layer has a centrosymmetric structure and includes multiple graded layers. In the technical solutions provided by this embodiment of the present invention, the compositionally-graded symmetrical multiplication layer is used to suppress ionization of a carrier, thereby further reducing an excess noise factor and noise by reducing the K value. Further, the charge layer is used to optimize the electrical field distribution of the avalanche photodiode, thereby reducing noise.

The foregoing descriptions are merely exemplary embodiments of the present invention, but arc not intended to limit the present invention.

**Claims**

1. An avalanche photodiode, wherein the avalanche photodiode comprises: a P-type contact layer (11), a light absorption layer (12), a compositionally-graded symmetrical multiplication layer (13), and an N-type contact layer (14), wherein the P-type contact layer (11) is connected to the light absorption layer (12), the light absorption layer (12) is connected to the compositionally-graded symmetrical multiplication layer (13), and the compositionally-graded symmetrical multiplication (13) layer is connected to the N-type contact layer (14); and
the compositionally-graded symmetrical multiplication layer (13) is configured to amplify an electrical signal, **characterized in that** the compositionally-graded symmetrical multiplication layer (13) has a centrosymmetric structure and comprises multiple graded layers.

2. The avalanche photodiode according to claim 1, wherein a material of the avalanche photodiode is a SiGe material.

3. The avalanche photodiode according to claim 2, wherein the avalanche photodiode further comprises a charge layer (15), wherein
the charge layer (15) is configured to adjust an electric field distribution of each layer, the charge layer (15) has a doping concentration of greater than or equal to $10^{17}/cm^3$, the charge layer (15) has a thickness range of 50 nm to 200 nm, and the charge layer (15) is located between the light absorption layer (12) and the compositionally-graded symmetrical multiplication layer (12).

4. The avalanche photodiode according to claim 2, wherein the P-type contact layer (11) has a doping concentration of greater than or equal to $10^{19}/cm^3$, and the P-type contact layer has a thickness range of 100 nm to 200 nm.

5. The avalanche photodiode according to claim 2, wherein the light absorption layer (12) has a thickness range of 200 nm to 2000 nm.

6. The avalanche photodiode according to claim 2, wherein the light absorption layer (12) is a P-doped light absorption layer, and the P-doped light absorption layer has a doping concentration of greater than or equal to $10^{17}/cm^3$;
or
the light absorption layer (12) is an undoped light absorption layer, and the undoped light absorption layer has a doping concentration of less than or equal to $10^{16}/cm^3$.

7. The avalanche photodiode according to claim 1, wherein the N-type contact layer (14) has a doping concentration of greater than or equal to $10^{19}/cm^3$, and the N-type contact layer (14) is connected to the compositionally-graded symmetrical multiplication layer.

8. The avalanche photodiode according to claim 1, wherein a composition of the compositionally-graded symmetrical multiplication layer (13) is a lattice mismatched material that is symmetrically distributed, and the symmetrical distribution refers to that as positions of the graded layers in the compositionally-graded symmetrical multiplication layer (13) change, content of a first crystal material in the graded layers increases from o to 100%, and then decreases from 100% to o.

9. The avalanche photodiode according to claim 1, wherein a band gap width of a material of two ends in the compositionally-graded symmetrical multiplication layer (13) is less than a band gap width of the graded layer.

10. The avalanche photodiode according to claim 1, wherein a thickness of each graded layer in the compositionally-graded symmetrical multiplication layer (13) is less than or equal to a reciprocal of an ionization rate of a multiplied carrier of the graded layer.

**Patentansprüche**

1. Lawinen-Fotodiode, wobei die Lawinen-Fotodiode umfasst: eine p-Kantaktschicht (11), eine Lichtabsorptionsschicht (12), eine hinsichtlich der Zusammensetzung abgestufte symmetrische Vervielfachungsschicht (13) und eine n-Kontaktschicht (14), wobei die p-Kontaktschicht (11) mit der Lichtabsorptionsschicht (12) verbunden ist, die Lichtabsorptionsschicht (12) mit der hinsichtlich der Zusammensetzung abgestuften symmetrischen Vervielfachungsschicht (13) verbunden ist, und die hinsichtlich der Zusammensetzung abgestufte symmetrische Vervielfachungsschicht (13) mit der n-Kantaletschicht (14) verbunden ist; und die hinsichtlich der Zusammensetzung abgestufte symmetrische Vervielfachungsschicht (13) zum Verstärken eines elektrischen Signals ausgelegt ist, **dadurch gekennzeichnet, dass** die hinsichtlich der Zusammensetzung abgestufte symmetrische Vervielfachungsschicht (13) eine zentralsymmetrische Struktur aufweiset und mehrere abgestufte Schichten umfasst.

2. Lawinen-Fotodiode nach Anspruch 1, wobei ein Material der Lawinen-Fotodiode ein SiGe-Material ist.

3. Lawinen-Fotodiode nach Anspruch 2, wobei die Lawinen-Fotodiode ferner eine Ladungsschicht (15) umfasst, wobei die Ladungsschicht (15) zum Anpassen einer Verteilung des elektrischen Feldes jeder Schicht ausgelegt ist, die Ladungsschicht (15) eine Dotierungskonzentration von über oder gleich $10^{17}/cm^3$ aufweist, die Ladungsschicht (15) einen Dickenbereich von 50 nm bis 200 nm aufweist, und die Ladungsschicht (15) zwischen der Lichtabsorptionsschicht (12) und der hinsichtlich der Zusammensetzung abgestuften symmetrischen Vervielfachungsschicht (12) angeordnet ist.

4. Lawinen-Fotodiode nach Anspruch 2, wobei die p-Kontaktschicht (11) eine Dotierungskonzentration von über oder gleich $10^{19}/cm^3$ aufweist, und die p-Kontaktschicht einen Dickenbereich von 100 nm bis 200 nm aufweist.

5. Lawinen-Fotodiode nach Anspruch 2, wobei die Lichtabsorptionsschicht (12) einen Dickenbereich von 200 nm bis 2000 nm aufweist.

6. Lawinen-Fotodiode nach Anspruch 2, wobei die Lichtabsorptionsschicht (12) eine p-dotierte Lichtabsorptionsschicht ist, und die p-dotierte Lichtabsorptionsschicht eine Dotierungskonzentration von über oder gleich $10^{17}/cm^3$ aufweist; oder die Lichtabsorptionsschicht (12) eine undotierte Lichtabsorptionsschicht ist, und die undotierte Lichtabsorptionsschicht eine Dotierungskonzentration von unter oder gleich $10^{16}/cm^3$ aufweist.

7. Lawinen-Fotodiode nach Anspruch 1, wobei die n-Kontaktschicht (14) eine Dotierungskonzentration von über oder gleich $10^{19}/cm^3$ aufweist, und die n-Kontaktschicht (14) mit der hinsichtlich der Zusammensetzung abgestuften symmetrischen Vervielfachungsschicht verbunden ist.

8. Lawinen-Fotodiode nach Anspruch 1, wobei eine Zusammensetzung der hinsichtlich der Zusammensetzung abgestuften symmetrischen Vervielfachungsschicht (13) ein gitterfehlangepasstes Material ist, das symmetrisch verteilt ist, wobei sich die symmetrische Verteilung darauf bezieht, dass, wenn sich Positionen der abgestuften Schichten in der hinsichtlich der Zusammensetzung abgestuften symmetrischen Vervielfachungsschicht (13) ändern, ein Gehalt eines ersten Kristallmaterials in den abgestuften Schichten von 0 bis 100 % zunimmt und dann von 100 % bis 0 abnimmt.

9. Lawinen-Fotodiode nach Anspruch 1, wobei eine Bandlückenbreite eines Materials zweier Enden in der hinsichtlich der Zusammensetzung abgestuften symmetrischen Vervielfachungsschicht (13) kleiner als eine Bandlückenbreite der abgestuften Schicht ist.

10. Lawinen-Fotodiode nach Anspruch 1, wobei eine Dicke jeder abgestuften Schicht in der hinsichtlich der Zusammensetzung abgestuften symmetrischen Vervielfachungsschicht (13) kleiner als oder gleich wie ein Kehrwert einer Ionisierungsrate eines vervielfachten Trägers der abgestuften Schicht ist.

**Revendications**

1. Photodiode à avalanche, la photodiode à avalanche comprenant: une couche de contact de type P (11), une couche d'absorption de lumière (12), une couche de multiplication à gradient de composition symétrique (13), et une couche de contact de type N (14), dans laquelle la couche de contact de type P (11) est reliée à la couche d'absorption de lumière (12), la couche d'absorption de lumière (12) est reliée à la couche de multiplication à gradient de composition symétrique (13), et la couche de multiplication à gradient de composition symétrique (13) est reliée à la couche de contact de type N (14) ; et la couche de multiplication à gradient de composition symétrique (13) est configurée pour amplifier un signal électrique, **caractérisée en ce que** la couche de multiplication à gradient de composition symétrique (13) a une structure centrosymétrique et comprend de multiples couches à gradient.

2. Photodiode à avalanche selon la revendication 1, un matériau de la photodiode à avalanche étant un matériau SiGe.

3. Photodiode à avalanche selon la revendication 2, la photodiode à avalanche comprenant en outre une couche de charge (15), la couche de charge (15) étant configurée pour ajuster une distribution de champ électrique de chaque couche, la couche de charge (15) ayant une concentration de dopage supérieure ou égale à $10^{17}/cm^3$, la couche de charge (15) ayant une gamme d'épaisseur de 50 nm à 200 nm, et la couche de charge (15) étant située entre la couche d'absorption de lumière (12) et la couche de multiplication à gradient de composition symétrique (13).

4. Photodiode à avalanche selon la revendication 2, dans laquelle la couche de contact de type P (11) a une concentration de dopage supérieure ou égale à $10^{19}/cm^3$, et la couche de contact de type P a une gamme d'épaisseur de 100 nm à 200 nm.

5. Photodiode à avalanche selon la revendication 2, dans laquelle la couche d'absorption de lumière (12) a une gamme d'épaisseur de 200 nm à 2000 nm.

6. Photodiode à avalanche selon la revendication 2, dans laquelle la couche d'absorption de lumière (12) est une couche d'absorption de lumière dopée P, et la couche d'absorption de lumière dopée P a une concentration de dopage supérieure ou égale à $10^{17}/cm^3$ ; ou

la couche d'absorption de lumière (12) est une couche d'absorption de lumière non dopée, et la couche d'absorption de lumière non dopée a une concentration de dopage inférieure ou égale à $10^{16}/cm^3$.

7. Photodiode à avalanche selon la revendication 1, dans laquelle la couche de contact de type N (14) a une concentration de dopage supérieure ou égale à $10^{19}/cm^3$, et la couche de contact de type N (14) est reliée à la couche de multiplication à gradient de composition symétrique.

8. Photodiode à avalanche selon la revendication 1, dans laquelle une composition de la couche de multiplication à gradient de composition asymétrique (13) est un matériau à désaccord de maille qui est distribué symétriquement, et la distribution symétrique fait référence au fait que lorsque les positions des couches à gradient dans la couche de multiplication à gradient de composition symétrique (13) changent, la teneur d'un premier matériau cristallin dans les couches à gradient augmente de 0 à 100 %, et diminue ensuite de 100 % à 0.

9. Photodiode à avalanche selon la revendication 1, dans laquelle une largeur de bande interdite d'un matériau de deux extrémités dans la couche de multiplication à gradient de composition symétrique (13) est inférieure à une largeur de bande interdite de la couche à gradient.

10. Photodiode à avalanche selon la revendication 1, dans laquelle une épaisseur de chaque couche à gradient dans la couche de multiplication à gradient de composition symétrique (13) est inférieure ou égale à un inverse d'un taux d'ionisation d'un porteur multiplié de la couche à gradient.

| P-type contact layer 11 |
| Light absorption layer 12 |
| Compositionally-graded symmetrical multiplication layer 13 |
| N-type contact layer 14 |

FIG. 1

| P-type contact layer 11 |
| Light absorption layer 12 |
| Charge layer 15 |
| Compositionally-graded symmetrical multiplication layer 13 |
| N-type contact layer 14 |

FIG. 2

Compositionally-graded symmetrical multiplication layer

Germanium

Silicon

Germanium

FIG. 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0629005 A2